# EUROPEAN PATENT APPLICATION

(11) **EP 1 641 036 A1**
(43) Date of publication of application: **29.03.2006**
(21) Application number: 04746629.7
(22) Date of filing: 29.06.2004
(51) Int. Cl.: H01L 21/60

(54) **JOINING METHOD AND JOINING DEVICE**

(30) Priority: 02.07.2003 JP 2003270304
(71) Applicant: TOKYO ELECTRON LIMITED, Minato-ku, Tokyo 107-8481 (JP)
(72) Inventor: ARUGA, Tsuyoshi c/o Tokyo Electron AT Limited, Nirasaki-shi, Yamanashi 4078511 (JP); HAGIHARA, Junichi c/o Tokyo Electron AT Limited, Nirasaki-shi, Yamanashi 4078511 (JP)
(74) Representative: Liesegang, Eva
(86) International application number: PCT/JP2004/009160
(87) International publication number: WO 2005/004225

(57) **Abstract**

The present invention relates to a bonding method of bonding a first object to be bonded and a second object to be bonded by a pressurizing operation. The bonding method of the present invention is a first step of causing a first holding member and a second holding member to respectively hold the first object to be bonded and the second object to be bonded in such a manner that a bonding surface of the first object to be bonded and a holding surface of the second object to be bonded face to each other, a second step of treating the bonding surface of the first object to be bonded and the holding surface of the second object to be bonded with a treatment liquid under a condition wherein the first object to be bonded and the second object to be bonded are held by the first holding member and the second holding member, and a third step of pressurizing the first object to be bonded and the second object to be bonded toward each other by the first holding member and the second holding member in order to bond both the bonding surfaces close to each other.

## Description

### TECHNICAL FIELD

The present invention relates to a bonding method and a bonding apparatus, in particular to a bonding method and a bonding apparatus used in an assembling step of a semiconductor device.

### BACKGROUND ART

As electronic equipments such as cellular phones, portable information terminals or high-performance servers are spread, semiconductor devices used therein have been required higher function, higher processing speed and more miniaturization. Herein, in order to achieve the higher function and the higher processing speed in one semiconductor device, a large-scale chip development is necessary, which may involve a longer length and a higher cost of the development. Thus, a packaging structure such as a system-in-package (SiP) has been proposed, wherein a plurality of chips and/or passive components that have different functions is contained in one package.

In such a small high-density packaging structure, if a connection between chips or a connection between a chip and a wiring board such as an interposer is conducted by a bonding wire, it may be impossible to increase a wiring density thereof, inductance thereof may be too great, and radio-frequency noise caused by a switching operation may be too great. In addition, if a soldered bump is used instead of the bonding wire, a size in height thereof may be larger by a size of the bump, the number of steps may be increased because of a bump forming step, and reliability of the bonded part may be low.

Thus, instead of using the bonding wire and/or the soldered bump, wiring structures and/or outside connection electrodes, which are made of Cu or the like and exposed at a surface of a semiconductor wafer, a chip or a wiring board, are directly connected in a packaging structure (For example, Japanese Patent Laid-Open publication No. 2001-53218, preprint of "2001 International Conference on Electronics packaging" on pages 39 to 43).

However, when a wiring structure of a silicon chip and a wiring structure of an interposer are connected to each other, or when wiring structures of silicon chips are connected to each other, it may be difficult to conduct a bonding operation with high reliability, because an oxide film or the like is formed at a connecting (bonding) part from a completion of manufacture of individual chips to a start of the bonding step.

### DISCLOSURE OF THE INVENTION

Accordingly, it is an object of the present invention to solve the aforesaid problems and to provide a bonding technology capable of removing the effect of an oxide film or the like at a bonding part and achieving a bonded structure with high reliability.

In addition, it is an object of the present invention to provide a bonding technology capable of achieving improved reliability and yield in an assembling step of a semiconductor device or the like in which wiring structures of objects to be bonded are directly bonded to each other.

In order to solve the above problems, the present invention is a bonding method of bonding a first object to be bonded and a second object to be bonded by a pressurizing operation, the bonding method comprising: a first step of causing a first holding member and a second holding member to respectively hold the first object to be bonded and the second object to be bonded in such a manner that a bonding surface of the first object to be bonded and a holding surface of the second object to be bonded face to each other; a second step of treating the bonding surface of the first object to be bonded and the holding surface of the second object to be bonded with a treatment liquid under a condition wherein the first object to be bonded and the second object to be bonded are held by the first holding member and the second holding member; and a third step of pressurizing the first object to be bonded and the second object to be bonded toward each other by the first holding member and the second holding member in order to bond both the bonding surfaces close to each other.

According to the present invention, when the first object to be bonded and the second object to be bonded are bonded, a removing operation of oxide films on both the bonding surfaces, a cleaning operation of both the bonding surfaces and a treating operation such as application of a surface active agent are conducted at a place wherein the bonding step is carried out, i.e., in an apparatus wherein the bonding step is carried out, and then the first object to be bonded and the second object to be bonded are pressurized to each other. Thus, the bonding surfaces can be bonded closely under a clean condition wherein the oxide films or the like have been removed. Thus, failure in electrical bonding and/or strength that may be caused by the oxide films can be surely prevented, so that a bonding operation with high reliability can be achieved.

Preferably, the first step includes a step of detecting an image of the bonding surface of the first object to be bonded and an image of the bonding surface of the second object to be bonded under the condition wherein the first object to be bonded and the second object to be bonded are held by the first holding member and the second holding member, and of positioning the first object to be bonded and the second object to be bonded based on both the images.

In addition, preferably, the second step includes a step of forming a treatment space for containing the first object to be bonded and the second object to be bonded, and of introducing the treatment liquid into the treatment space.

In addition, preferably, the second step includes a step of removing oxide films on both the bonding surfaces by a medicament, and a step of cleaning both the bonding surfaces by a cleaning liquid.

In addition, preferably, the third step includes a heating step of heating the first holding member and the second holding member in order to promote bonding between both the bonding surfaces.

In addition, preferably, the heating step includes a step of heating the first holding member and the second holding member at a first temperature just after both the bonding surfaces are brought in close contact with each other, and a step of heating the first holding member and the second holding member at a second temperature higher than the first temperature.

In addition, preferably, a wiring structure is formed and exposed on each of the bonding surfaces, and both the wiring structures are brought in close contact with each other when both the bonding surfaces are brought in close contact with each other. In the case, preferably, the wiring structure is made of Cu. Alternatively, preferably, each of the bonding surfaces is, at least partly, made of Cu.

For example, the first object to be bonded is any of a semiconductor wafer, an interposer, a semiconductor tip, a package and a printed wiring board, and the second object to be bonded is any of a semiconductor wafer, an interposer, a semiconductor tip, a package and a printed wiring board.

In addition, the present invention is a bonding apparatus comprising: a first holding member and a second holding member that respectively hold a first object to be bonded and a second object to be bonded in such a manner that a bonding surface of the first object to be bonded and a holding surface of the second object to be bonded face to each other; a pressurizing mechanism that conducts a pressurizing operation of both the bonding surfaces toward each other by bringing the first holding member and the second holding member closer to each other; a treatment chamber that forms a treatment space for containing the first object to be bonded and the second object to be bonded respectively held by the first holding member and the second holding member; a treatment-liquid supplying mechanism that supplies a treatment liquid into the treatment chamber; and a treatment-liquid discharging mechanism that discharges the treatment liquid from the treatment chamber.

Preferably, the bonding apparatus further comprises a positioning mechanism that conducts a relative positioning operation of the first object to be bonded and the second object to be bonded respectively held by the first holding member and the second holding member.

In addition, preferably, the bonding apparatus further comprises a first head member that supports the first holding member, and a second head member that supports the second holding member, wherein the treatment chamber includes: a first chamber wall supported by the first head member and arranged so as to surround the first holding member; a second chamber wall supported by the second holding member and arranged so as to surround the second object to be bonded held by the second holding member; a first sealing member that seals a connection part between the first chamber wall and the second chamber wall; and a second sealing member that seals a gap between the first holding member and the first chamber wall.

In addition, preferably, the treatment-liquid supplying mechanism and the treatment-liquid discharging mechanism cooperate to sequentially conduct an operation of removing oxide films on both the bonding surfaces by supplying a medicament as a treatment liquid, and an operation of cleaning both the bonding surfaces by supplying a cleaning liquid as a treatment liquid.

In addition, preferably, the first head member is further provided with a first heating mechanism arranged capably of abutting with a back side of the first holding member, the first heating mechanism heating the first object to be bonded held by the first holding member, and a first heater-driving mechanism that conducts an abutting operation and a separating operation of the first heating mechanism to the back side of the first holding member, and the second head member is further provided with a second heating mechanism arranged capably of abutting with a back side of the second holding member, the second heating mechanism heating the second object to be bonded held by the second holding member, and a second heater-driving mechanism that conducts an abutting operation and a separating operation of the second heating mechanism to the back side of the second holding member.

In addition, preferably, the first heating mechanism is capable of abutting with the first holding member and heating the first holding member under a condition wherein the first heating mechanism has been heated at a predetermined first temperature in advance, and then capable of heating the first holding member at a second temperature higher than the first temperature, and the second heating mechanism is capable of abutting with the second holding member and heating the second holding member under a condition wherein the second heating mechanism has been heated at a predetermined first temperature in advance, and then capable of heating the second holding member at a second temperature higher than the first temperature.

In addition, preferably, the first holding member is provided with a absorbing-and-holding member that absorbs and holds the first object to be bonded in a removable manner, and the second holding member is provided with a absorbing-and-holding member that absorbs and holds the second object to be bonded in a removable manner.

In addition, preferably, the positioning mechanism includes a first camera that takes an image of the second object to be bonded held by the second holding member and a second camera that takes an image of the first object to be bonded held by the first holding member, and is adapted to align both the bonding surfaces by relatively moving the first head member and the second head member in accordance with positional recognition based on both the images.

### BRIEF DESCRIPTION OF THE DRAWINGS

Fig. 1 is a sectional view showing an example of structure of a bonding apparatus carrying out a bonding method according to an embodiment of the present invention;
Fig. 2 is a sectional view showing an example of operation of the bonding apparatus shown in Fig. 1;
Fig. 3 is a sectional view showing the example of operation of the bonding apparatus shown in Fig. 1;
Fig. 4 is a sectional view showing the example of operation of the bonding apparatus shown in Fig. 1;
Fig. 5 is a sectional view showing the example of operation of the bonding apparatus shown in Fig. 1;
Fig. 6 is a sectional view showing the example of operation of the bonding apparatus shown in Fig. 1;
Fig. 7 is a substantially plan view showing an example of the whole structure of a bonding system including the bonding apparatus according to the embodiment of the present invention;
Fig. 8 is a flow chart showing an example of operation of the bonding system shown in Fig. 7; and
Fig. 9 is a substantially sectional view showing an example of object to be bonded that is supplied for a bonding apparatus according to an embodiment of the present invention.

### BEST MODE FOR CARRYING OUT THE INVENTION

Preferred embodiments of the present invention will be described hereinafter with reference to the attached drawings.

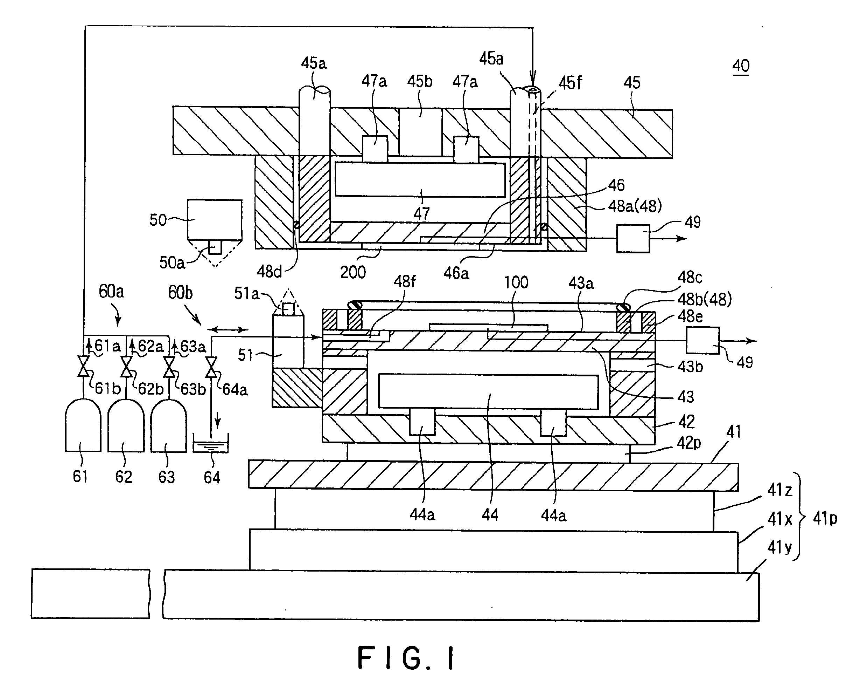

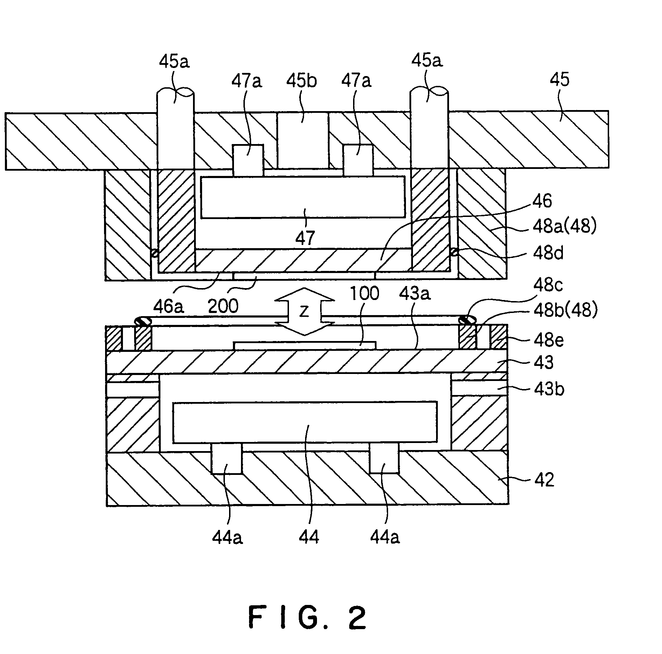

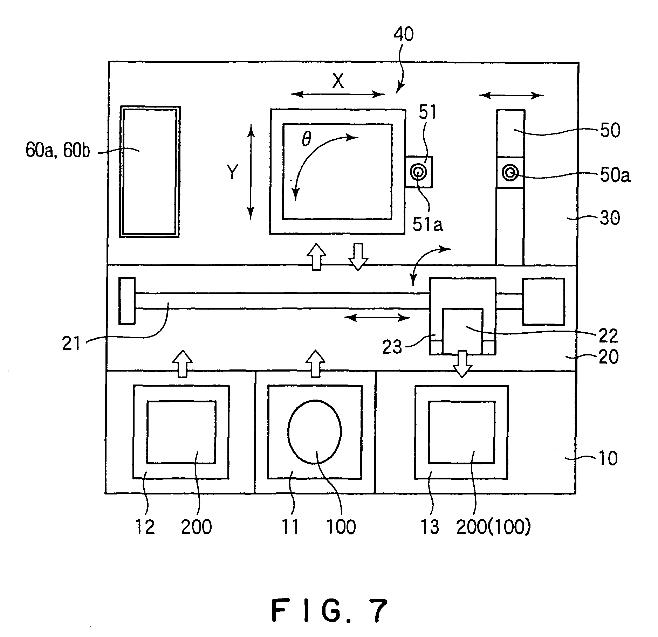

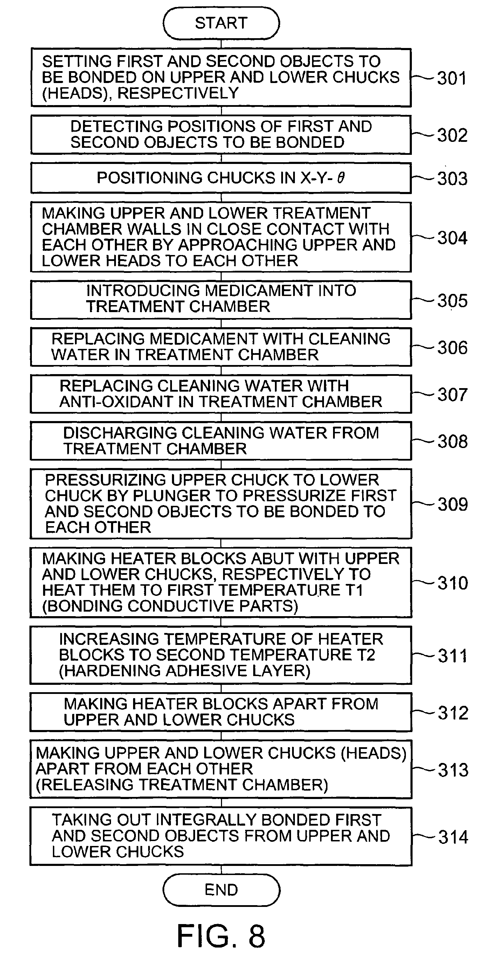

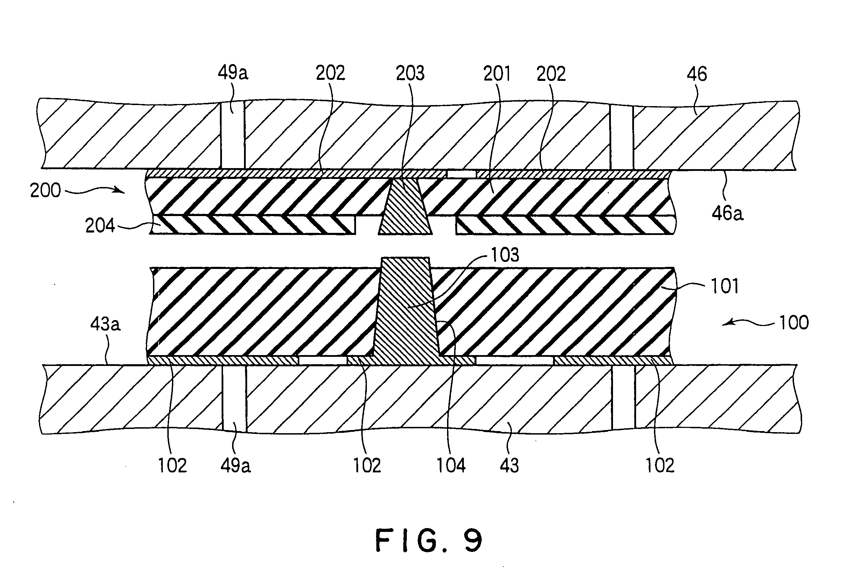

Fig. 1 is a sectional view showing an example of structure of a bonding apparatus carrying out a bonding method according to an embodiment of the present invention. Figs. 2 to 6 are sectional views showing an example of operation of the bonding apparatus shown in Fig. 1. Fig. 7 is a substantially plan view showing an example of the whole structure of a bonding system including the bonding apparatus of the present embodiment. Fig. 8 is a flow chart for showing an example of operation of the bonding system shown in Fig. 7. Fig. 9 is a substantially sectional view showing an example of object to be bonded.

In the present embodiment, as an example, a bonding operation of an interposer and a semiconductor wafer is explained.

As shown in Fig. 7, the bonding system of the present embodiment comprises a bonding mechanism 30, a loading/unloading part 10, and a transferring mechanism 20 located between them.

The bonding mechanism 30 includes: a bonding apparatus 40 arranged at a center of the bonding mechanism 30, a treatment-liquid supplying mechanism 60a that supplies a treatment liquid or the like into the bonding apparatus 40, and a treatment-liquid retrieving mechanism 60b that retrieves (discharges) the treatment liquid or the like.

The loading/unloading part 10 has: a wafer-supplying cassette 11 which a carrier (not shown) is supplied from an outside to and held by, the carrier containing a semiconductor wafer 100 as an example of first object to be bonded; an interposer-supplying cassette 12 which another carrier (not shown) is supplied from an outside to and held by, the carrier containing an interposer 200 as an example of second object to be bonded; and an outputting cassette 13 from which the semiconductor wafer 100 and the interposer 200 that have been integrally bonded are outputted as a finished piece.

The transferring mechanism 20 has a transfer way 21 arranged in a direction along the arrangement of the wafer-supplying cassette 11, the interposer-supplying cassette 12 and the outputting cassette 13 of the loading/unloading part 10. An arm robot 22 is provided movably on the transfer way 21. A holding arm 23 is provided on the arm robot 22 and is capable of pivoting from a position facing the loading/unloading part 10 to a position facing the bonding mechanism 30.

The holding arm 23 is adapted to take out the semiconductor wafer 100 to be bonded from the wafer-supplying cassette 11 and the interposer 200 to be bonded from the interposer-supplying cassette 12, hold them, and set them at the bonding apparatus 40. In addition, the bolding arm 23 is adapted to take out a bonded finished piece from the bonding apparatus 40 and set it into the outputting cassette 13.

On the other hand, as shown in Fig. 1, the bonding apparatus 40 of the present embodiment has: a lower head 41 connected to a positioning mechanism 41P, which mechanism can achieve a parallel displacement in a horizontal plane (X-Y plane in Fig. 7) and a positioning in a vertical direction (vertical (Z) direction in Fig. 1), a rotation table 42 connected to a positioning mechanism 42P, which mechanism is supported by the lower head 41 and can achieve a rotational positioning (θ direction in Fig. 7) in the X-Y plane, a lower chuck 43 supported by the rotation table 42 and having a cylindrical shape with a ceiling, whose surface forms an absorption surface 43a on which the first object to be bonded such as the semiconductor wafer 100 is placed, and a lower heater 44 arranged in the lower chuck 43. The positioning mechanism 41P consists of: a cylindrical part 41z supporting the lower head 41 and positioning the lower head 41 in a vertical direction; an X-stage 41x supporting the cylindrical part 41z and positioning the cylindrical part 41z in an X direction; and a Y-stage 41y supporting the X-stage 41x and positioning the X-stage 41x in a Y direction. The lower heater 44 can freely control a heating temperature by a control of amount of electric conduction or the like. In addition, the lower heater 44 is supported by the rotation table 42 via a heater-elevating mechanism 44a, and is movable between a heating position in close contact with a back surface of the ceiling that forms the absorption surface 43a of the lower chuck 43 and a non-heating position apart from the ceiling.

A ventilation hole 43b is opened at a lateral wall of the lower chuck 43. A temperature control of the lower chuck 43 is achieved by causing an air or the like for cooling or heating to flow from the ventilation hole 43b into the lower chuck 43, if necessary.

A plurality of vacuum-absorption holes 49a (see Fig. 9) is opened at the absorption surface 43a of the lower chuck 43, correspondingly to an area where the semiconductor wafer 100 as the first object to be bonded is placed. By means of the vacuum absorption via the vacuum-absorption holes 49a, the semiconductor wafer 100 delivered from the arm robot 22 is adapted to be held on the absorption surface 43a in a removable manner.

On the other hand, above the lower chuck 43, an upper head 45 is oppositely provided, which is movable up and down in the Z direction (vertical direction). An upper chuck 46 having a cylindrical shape with a bottom is supported by the upper head 45 via a pressuring mechanism 45a that generates a pressurizing force in the Z direction. The bottom of the upper chuck 46 forms an absorption surface 46a opposite and parallel to the absorption surface 43a of the lower chuck 43.

A plurality of vacuum-absorption holes 49a is opened at the absorption surface 46a of the upper chuck 46, correspondingly to an area where the interposer 200 as the second object to be bonded is placed. By means of the vacuum absorption via the vacuum-absorption holes 49a, the interposer 200 delivered from the arm robot 22 is adapted to be held on the absorption surface 46a in a removable manner.

The upper chuck 46 and the lower chuck 43 opposite to each other are adapted to pressurize and bond the semiconductor wafer 100 and the interposer 200 as the objects to be bonded, by means of the pressurizing force in the Z direction generated by the pressurizing mechanism 45a.

An upper heater 47 is provided in the upper chuck 46. The upper heater 47 can freely control a heating temperature by a control of amount of electric conduction or the like. In addition, the upper heater 47 is supported by the upper head 45 via a heater-elevating mechanism 47a, and is movable between a heating position in close contact with an upper surface of the bottom that forms the absorption surface 46a of the lower chuck 46 and a non-heating position apart from the bottom.

A ventilation hole 45b is formed at the upper head 45 so as to communicate with the inside of the upper chuck 46. A temperature control of the upper chuck 46 is achieved by causing an air or the like for cooling or heating to flow from the ventilation hole 45b, if necessary.

An upper chamber wall 48a is projected from the upper head 45 so as to surround the upper chuck 46 absorbing and holding the interposer 200. A lower chamber wall 48b corresponding to the upper chamber wall 48a is projected from the lower chuck 43 so as to surround a holding area for the semiconductor wafer 100. Then, a treatment chamber 48 is adapted to be formed when the upper chamber wall 48a and the lower chamber wall 48b are brought in close contact with each other.

A sealing member 48c, such as an O-ring, is arranged fully circumferentially at an opening part of the lower chamber wall 48b. Thus, air tightness is maintained when the upper chamber wall 48a and the lower chamber wall 48b are brought in close contact with each other. In addition, a sealing member 48d, such as an O-ring, for hermetically sealing a gap between the upper chuck 46 and the upper chamber wall 48a is fitted on an outside periphery of the upper chuck 46. In addition, outside the lower chamber wall 48b, an overflow-preventing wall 48e is provided for retrieving a treatment liquid that has overflown over the lower chamber wall 48b.

A treatment-liquid supplying way 45f is opened at the upper chuck 45 inside the upper chamber wall 48a. The treatment-liquid supplying way 45f is connected to a treatment-liquid supplying mechanism 60a. Thus, a medicament or a cleaning liquid can be introduced from the treatment-liquid supplying mechanism 60a into the treatment chamber 48.

On the other hand, a treatment-liquid discharging way 48f is opened at the lower chuck 43 inside the lower chamber wall 48b. The treatment-liquid discharging way 48f is connected to a treatment-liquid retrieving mechanism 60b. Thus, the medicament or the cleaning liquid or the like introduced from the treatment-liquid supplying mechanism 60a into the treatment chamber 48 can be discharged to the treatment-liquid retrieving mechanism 60b after the treatment.

The treatment-liquid supplying mechanism 60a comprises: a medicament supplying part 61 that supplies a medicament 61a such as hydrochloric acid, a cleaning-liquid supplying part 62 that supplies a cleaning liquid 62a such as purified water, and a surface-treatment-liquid supplying part 63 that supplies a surface treatment liquid 63a such as PGME (propyleneglycol monomethyl ether).

The treatment-liquid retrieving mechanism 60b has a retrieving part 64 for retrieving the respective discharged liquids after the treatment from the treatment chamber 48.

The medicament supplying part 61 is adapted to supply the medicament 61a via a valve 61b. The cleaning-liquid supplying part 62 is adapted to supply the cleaning liquid 62a via a valve 62b. The surface-treatment-liquid supplying part 63 is adapted to supply a surface treatment liquid 63a via a valve 63b. The retrieving part 64 is adapted to retrieve the discharged liquids via a valve 64a.

The vacuum absorption by the vacuum-absorption holes 49a of the lower chuck 43 and the upper chuck 46 is turned on and off, so that the semiconductor wafer 100 and the interposer 200 can be absorbed and held in a removable manner. In the present embodiment, it is possible that the medicament or the like is sucked out from the vacuum-absorption holes 49a. Thus, instead of a vacuum pump having a complex structure, an ejector 49 having a simple structure and relatively easy to achieve sufficient resistance to chemicals is connected to the vacuum-absorption holes 49a.

A lower alignment mechanism 51 is provided on a lateral surface of the lower chuck 43. The lower alignment mechanism 51 consists of a lower camera that has an image-taking part 51a oriented upward in order to take an image of the interposer 200 held by the upper chuck 46 and to detect positional information thereof.

In addition, an upper alignment mechanism 50 is arranged at a position higher than the lower chuck 43. The upper alignment mechanism 50 comprises a camera that has an image-taking part 50a oriented downward in order to take an image of the semiconductor wafer 100 held by the lower chuck 43 and to detect positional information thereof.

Next, with reference to Fig. 9, an example of structure of the semiconductor wafer 100 and the interposer 200 as the objects to be bonded in the present embodiment is explained.

The semiconductor wafer 100 has a silicon substrate 101, a wiring pattern 102 formed on a surface of the silicon substrate 101, and a plurality of connection electrodes 103 buried in throughholes 104 piecing through the silicon substrate 101. One ends of the connection electrodes 103 are connected to the wiring pattern 102, and the other ends of the connection electrodes 103 are exposed at a back surface of the silicon substrate 101. The connection electrodes 103 consist of a conductive material such as Cu.

On the other hand, the interposer 200 has an insulating substrate 201, a wiring pattern 202 formed on a surface of the insulating substrate 201, and a plurality of connection electrodes 203 piecing through the insulating substrate 201. One ends of the connection electrodes 203 are connected to the wiring pattern 202, and the other ends of the connection electrodes 203 are exposed at a back surface of the insulating substrate 201. The connection electrodes 203 consist of a conductive material such as Cu. If necessary, an adhesive 204 is applied on the back surface of the insulating substrate 201 where the connection electrodes 203 are exposed. The adhesive 204 may be omitted.

Then, in the bonding apparatus 40 of the present embodiment, the connection electrodes 103 exposed at the back surface of the semiconductor wafer 100 and the connection electrodes 203 exposed at the back surface of the interposer 200 are aligned, brought in close contact with each other, and hence electrically connected to each other.

Then, with reference to the flow chart of Fig. 8 or the like, an example of operation of the bonding apparatus of the present embodiment is explained.

At first, as shown in Fig. 1, the lower chuck 43 (lower head 41) and the upper chuck 46 (upper head 45) are made apart. At that time, the upper chuck 46 is located (withdrawn) in the upper chamber wall 48a. In addition, the lower heater 44 and the upper heater 47 are respectively located apart from the absorption surface 43a and the absorption surface 46a, and preheated at a predetermined first temperature T1 (for example, 120 °C).

Under the condition, by means of the arm robot 22, the semiconductor wafer 100 and the interposer 200 are respectively set on the absorption surface 43a of the lower chuck 43 and the absorption surface 46a of the upper chuck 46, and absorbed and held by them (STEP 301).

Specific positions of the semiconductor wafer 100 and the interposer 200 respectively set on the lower chuck 43 and the upper chuck 46 (specifically, for example, positioning marks thereof that have been formed in advance) are detected by the upper alignment mechanism 50 and the lower alignment mechanism 51 (STEP 302), and positional differences between them in the horizontal (X-Y) direction and in the rotational (θ) direction are detected. So as to cancel the positional differences, the lower head 41 and the rotation table 42 are suitably moved and positioned with respect to the upper head 45 (STEP 303).

Thus, the individual connection electrodes 103 of the semiconductor wafer 100 and the corresponding individual connection electrodes 203 of the interposer 200 are positioned to be correctly overlapped in the vertical direction.

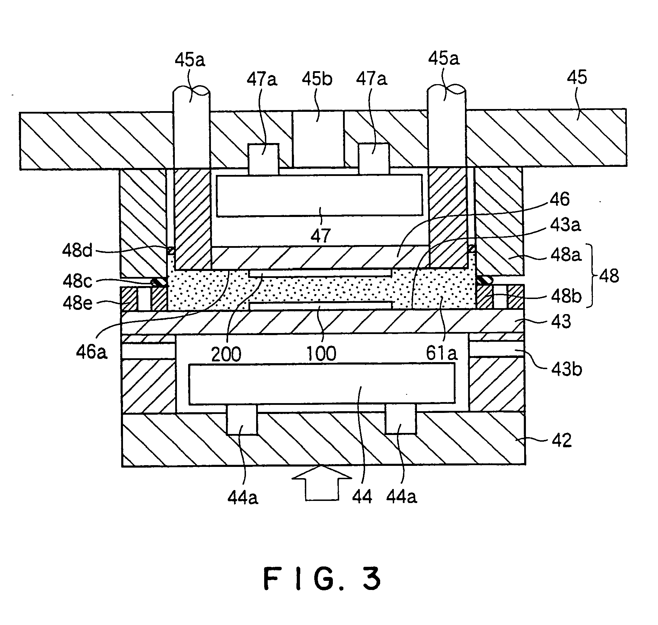

Then, for example by moving up the lower head 41, the lower chamber wall 48b and the upper chamber wall 48a are made in close contact with each other, so that the hermetically closed treatment chamber 48 is formed (STEP 304). Then, the medicament 61a such as hydrochloric acid is introduced from the medicament supplying part 61 into the treatment chamber 48 (STEP 305) (Fig. 3). Thus, oxide films on surfaces of the individual connection electrodes 103 of the semiconductor wafer 100 and the corresponding individual connection electrodes 203 of the interposer 200 are removed by the medicament 61a.

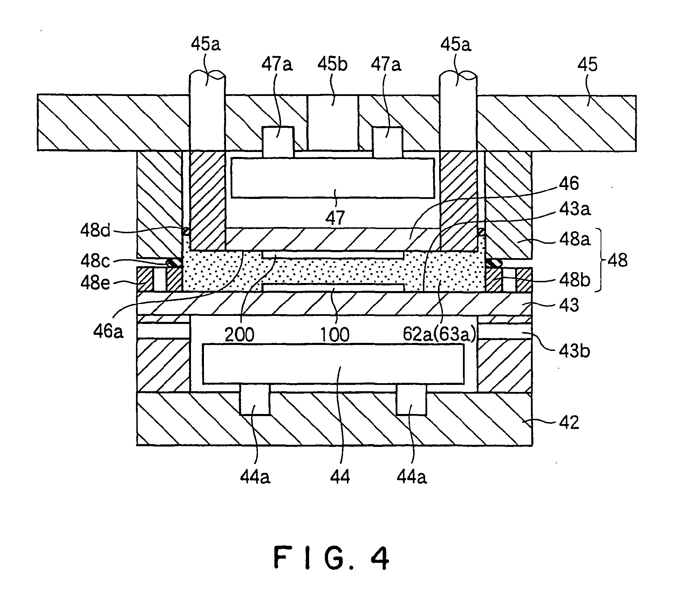

Then, the medicament 61a in the treatment chamber 48 is discharged, and the cleaning liquid 62a is introduced from the cleaning-liquid supplying part 62 in order to conduct a cleaning operation of removing the medicament 61a or the like (STEP 306) (Fig. 4). After the cleaning operation, if necessary, the surface treatment liquid 63a such as PGME is introduced from the surface-treatment-liquid supplying part 63 in order to conduct a surface treatment such as an anti-oxidant treatment onto the surfaces to be bonded (STEP 307).

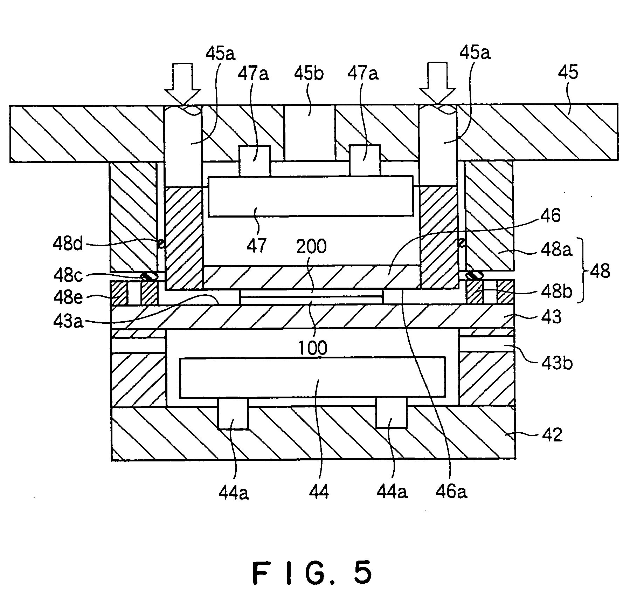

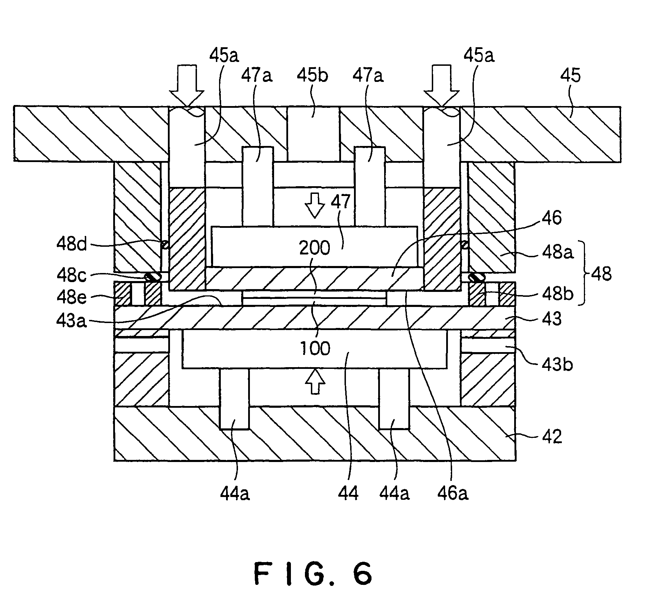

Then, after the cleaning liquid 62a and the surface treatment liquid 63a and the like in the treatment chamber 48 are completely discharged to the retrieving part 64 (STEP 308), by means of the pressurizing mechanism 45a, the upper chuck 46 is moved down, and hence the semiconductor wafer 100 and the interposer 200 are pressurized between the upper chuck 46 and the lower chuck 43 with a pressure of, for example, 3.48 kg/mm² (STEP 309) (Fig. 5). Then, the lower heater 44 is moved up so as to abut with the back surface of the ceiling that forms the absorption surface 43a of the lower chuck 43, and the upper heater 47 is moved down so as to abut with the upper surface of the bottom that forms the absorption surface 46a of the upper chuck 46. Thus, the semiconductor wafer 100 and the interposer 200 are rapidly heated to the first temperature T1 (for example, 120 °C). By means of the pressurizing force and the heat of the first temperature T1, the individual connection electrodes 103 of the semiconductor wafer 100 and the corresponding individual connection electrodes 203 of the interposer 200 are bonded (STEP 310) (Fig. 6).

In addition, if necessary, the heating temperature of the upper heater 47 and the lower heater 44 is increased to a higher second temperature T2 ( > T1: for example, 150 °C). Thus, the adhesive 204 is hardened to excise its adhesive force (STEP 311).

Then, the upper heater 47 and the lower heater 44 are respectively made apart from the upper chuck 46 and the lower chuck 43 (STEP 312). Then, the vacuum absorption of the absorption surface 46a is released, and the upper chuck 46 is moved up and withdrawn into the inside of the upper chamber wall 48a to be separated from the lower chuck 43. That is, the lower head 41 and the upper head 45 are made apart. Thus, the treatment chamber 48 is opened (STEP 313).

Then, the semiconductor wafer 100 and the interposer 200 that have been integrally bonded are taken out by the holding arm 23 of the arm robot 22, and transferred into the outputting cassette 13 (STEP 314).

As described above, according to the bonding apparatus of the present embodiment, when the individual connection electrodes 103 of the semiconductor wafer 100 and the corresponding individual connection electrodes 203 of the interposer 200 are directly bonded, in the bonding apparatus, on the surfaces of the connection electrodes 103 and the connection electrodes 203, the removing operation of the oxide films, the cleaning operation, the applying operation of the anti-oxidant if necessary, and the like are conducted. Thus, direct bonding of the connection electrodes 103 and the connection electrodes 203 can be achieved with a high reliability and a high bonding strength, without interposition of the oxide films.

In addition, the lower heater 44 and the upper heater 47 are heated at 120 °C in advance, and made in contact with the upper chuck 46 and the lower chuck 43, so that the semiconductor wafer 100 and the interposer 200 are rapidly heated. Thus, oxidation of the connection electrodes 103 and the connection electrodes 203 can be prevented, after the removing operation of the oxide films.

As a result, reliability and yield of products can be improved in an assembling step of a semiconductor device or the like including the bonding step.

Herein, the present invention is not limited to the above embodiment, but may be variously modified. For example, in the above embodiment, the semiconductor wafer and the interposer are bonded as the objects to be bonded. However, not limited thereto, the present invention is applicable to a bonding step of a semiconductor wafer and a semiconductor chip, a bonding step of an interposer and a semiconductor chip, a bonding step of an interposer and a package, a bonding step of a semiconductor wafer and a package, a bonding step of a semiconductor wafer and a printed wiring board, a bonding step of an interposer and a printed wiring board, a bonding step of a semiconductor chip and a package, a bonding step of a semiconductor chip and a printed wiring board, and a bonding step of any elements in an assembling step of a semiconductor device.

In addition, in the above embodiment, the lower chamber wall 48b and the upper chamber wall 48a that forms the treatment chamber 48 are provided integrally with the lower chuck 43 and the upper head 45, respectively. However, not limited thereto, the treatment chamber may be formed so as to be movable independently from the bonding apparatus. For example, at a cleaning operation just before a bonding operation, it is possible that members for forming a treatment chamber are inserted and held between the lower chuck 43 and the upper chuck 46, and that the semiconductor wafer 100 and the interposer 200 held by the lower chuck 43 and the upper chuck 46 are contained in the treatment chamber formed by the members.

As a medicament, hydrochloric acid, sulfuric acid, or the like may be used. In addition, oxide-film-removing liquid may be used.

As a cleaning liquid, purified water, lactic acid, THF (5,6,7,8-tetrahydrofolic acid), ethanol, IPA (isopropyl alcohol), cyclohexane, toluene, or the like may be used, corresponding to a material of a wiring pattern and/or adhesive.

In addition, the flow of the bonding step shown in the above embodiment may be variously modified within a scope of summary of the present invention.

In addition, according to the present invention, in an assembling step of a semiconductor device or the like wherein wiring structures of objects to be bonded are directly bonded, reliability and/or yield can be improved.

## Claims

1. A bonding method of bonding a first object to be bonded and a second object to be bonded by a pressurizing operation, the bonding method comprising
a first step of causing a first holding member and a second holding member to respectively hold the first object to be bonded and the second object to be bonded in such a manner that a bonding surface of the first object to be bonded and a holding surface of the second object to be bonded face to each other,
a second step of treating the bonding surface of the first object to be bonded and the holding surface of the second object to be bonded with a treatment liquid under a condition wherein the first object to be bonded and the second object to be bonded are held by the first holding member and the second holding member, and
a third step of pressurizing the first object to be bonded and the second object to be bonded toward each other by the first holding member and the second holding member in order to bond both the bonding surfaces close to each other.

2. A bonding method according to claim 1, wherein
the first step includes a step of detecting an image of the bonding surface of the first object to be bonded and an image of the bonding surface of the second object to be bonded under the condition wherein the first object to be bonded and the second object to be bonded are held by the first holding member and the second holding member, and of positioning the first object to be bonded and the second object to be bonded based on both the images.

3. A bonding method according to claim 1 or 2, wherein
the second step includes a step of forming a treatment space for containing the first object to be bonded and the second object to be bonded, and of introducing the treatment liquid into the treatment space.

4. A bonding method according to any of claims 1 to 3, wherein
the second step includes
a step of removing oxide films on both the bonding surfaces by a medicament, and
a step of cleaning both the bonding surfaces by a cleaning liquid.

5. A bonding method according to any of claims 1 to 4, wherein
the third step includes a heating step of heating the first holding member and the second holding member in order to promote bonding between both the bonding surfaces.

6. A bonding method according to claim 5, wherein
the heating step includes
a step of heating the first holding member and the second holding member at a first temperature just after both the bonding surfaces are brought in close contact with each other, and
a step of heating the first holding member and the second holding member at a second temperature higher than the first temperature.

7. A bonding method according to any of claims 1 to 6, wherein
a wiring structure is formed and exposed on each of the bonding surfaces, and
both the wiring structures are brought in close contact with each other when both the bonding surfaces are brought in close contact with each other.

8. A bonding method according to claim 7, wherein
the wiring structure is made of Cu.

9. A bonding method according to claim 7 or 8, wherein
each of the bonding surfaces is, at least partly, made of Cu.

10. A bonding method according to any of claims 1 to 9, wherein
the first object to be bonded is any of a semiconductor wafer, an interposer, a semiconductor tip, a package and a printed wiring board, and
the second object to be bonded is any of a semiconductor wafer, an interposer, a semiconductor tip, a package and a printed wiring board.

11. A bonding apparatus comprising,
a first holding member and a second holding member that respectively hold a first object to be bonded and a second object to be bonded in such a manner that a bonding surface of the first object to be bonded and a holding surface of the second object to be bonded face to each other,
a pressurizing mechanism that conducts a pressurizing operation of both the bonding surfaces toward each other by bringing the first holding member and the second holding member closer to each other,
a treatment chamber that forms a treatment space for containing the first object to be bonded and the second object to be bonded respectively held by the first holding member and the second holding member,
a treatment-liquid supplying mechanism that supplies a treatment liquid into the treatment chamber, and
a treatment-liquid discharging mechanism that discharges the treatment liquid from the treatment chamber.

12. A bonding apparatus according to claim 11, further comprising
a positioning mechanism that conducts a relative positioning operation of the first object to be bonded and the second object to be bonded respectively held by the first holding member and the second holding member.

13. A bonding apparatus according to claim 11 or 12, further comprising
a first head member that supports the first holding member, and
a second head member that supports the second holding member,
wherein
the treatment chamber includes:
a first chamber wall supported by the first head member and arranged so as to surround the first holding member,
a second chamber wall supported by the second holding member and arranged so as to surround the second object to be bonded held by the second holding member,
a first sealing member that seals a connection part between the first chamber wall and the second chamber wall, and
a second sealing member that seals a gap between the first holding member and the first chamber wall.

14. A bonding apparatus according to any of claims 11 to 13, wherein
the treatment-liquid supplying mechanism and the treatment-liquid discharging mechanism cooperate to sequentially conduct an operation of removing oxide films on both the bonding surfaces by supplying a medicament as a treatment liquid, and an operation of cleaning both the bonding surfaces by supplying a cleaning liquid as a treatment liquid.

15. A bonding apparatus according to any of claims 11 to 14, wherein
the first head member is further provided with
a first heating mechanism arranged capably of abutting with a back side of the first holding member, the first heating mechanism heating the first object to be bonded held by the first holding member, and
a first heater-driving mechanism that conducts an abutting operation and a separating operation of the first heating mechanism to the back side of the first holding member, and
the second head member is further provided with
a second heating mechanism arranged capably of abutting with a back side of the second holding member, the second heating mechanism heating the second object to be bonded held by the second holding member, and
a second heater-driving mechanism that conducts an abutting operation and a separating operation of the second heating mechanism to the back side of the second holding member.

16. A bonding apparatus according to any of claims 11 to 15, wherein
the first heating mechanism is capable of abutting with the first holding member and heating the first holding member under a condition wherein the first heating mechanism has been heated at a predetermined first temperature in advance, and then capable of heating the first holding member at a second temperature higher than the first temperature, and
the second heating mechanism is capable of abutting with the second holding member and heating the second holding member under a condition wherein the second heating mechanism has been heated at a predetermined first temperature in advance, and then capable of heating the second holding member at a second temperature higher than the first temperature.

17. A bonding apparatus according to any of claims 11 to 16, wherein
the first holding member is provided with a absorbing-and-holding member that absorbs and holds the first object to be bonded in a removable manner, and
the second holding member is provided with a absorbing-and-holding member that absorbs and holds the second object to be bonded in a removable manner.

18. A bonding apparatus according to any of claims 11 to 17, wherein
the positioning mechanism includes a first camera that takes an image of the second object to be bonded held by the second holding member and a second camera that takes an image of the first object to be bonded held by the first holding member, and is adapted to align both the bonding surfaces by relatively moving the first head member and the second head member in accordance with positional recognition based on both the images.
